# EUROPEAN PATENT APPLICATION

(11) **EP 0 631 288 A2**
(43) Date of publication of application: **28.12.1994**
(21) Application number: 94107115.1
(22) Date of filing: 06.05.1994
(51) Int. Cl.: G11C 11/406

(54) **Dynamic RAM controller and circuit for driving a plurality of banks of dynamic random access memories**

(30) Priority: 14.05.1993 IT MI930981
(71) Applicant: ALCATEL N.V., NL-1077 XX Amsterdam (NL); ALCATEL ITALIA S.p.A., I-20158 Milano (IT)
(72) Inventor: Gagliolo,Rosario, I-24030 Caprino Bergamasco(BG) (IT)
(74) Representative: Pohl, Herbert, Dipl.-Ing

(57) **Abstract**

The present invention relates to a dynamic RAM controller and to a circuit for driving a plurality of dynamic RAM banks. By making a dynamic RAM controller provides its current mode of operation (access/refresh) at its output.

It is possible to extend at will the possibilities of addressing of the controller itself; as a result, a sole controller is capable of handling several memory banks by merely adding a decoding logic for selection of the bank during the access operation mode. In this manner it is further obtained the advantage of having the refresh time tied only to the dimension of the memory bank and not to the number of memory banks since the refresh occurs in parallel on all memory banks.

## Description

The present invention relates to a dynamic RAM controller as set forth in the preamble of claim 1, and to a circuit for driving a plurality of banks of dynamic random access memory.

Dynamic random access memories are widely used semiconductor memories that have the advantage of allowing a high integration level; however, they have the disadvantage of requiring a periodic refresh because, should a memory location be not switched on for a time greater than a predetermined limit, its information content is irremediably lost. An example of such memories is the TMS44400 device manufactured by Texas Instrument and illustrated in Texas Instruments' DATA-BOOK "MOS Memory" 1991, pages 5-125 to 5-144.

As well known, such memories can basically operate in accordance with two modes of operation: a first (access) operation mode (write and/or read out) and a second (refresh) operation mode; moreover they feature the peculiarity of having an address input formed by a number of lines which, in general correspond to one half of the number of lines enough to address all their cells, and hence the addressing phase occurs by sending at first a first address called row-address, and subsequently a second address, called column-address, to their address input.

Because of their own pecularities, control integrated circuits called DRAM controller, which facilitate their management and in particular take care of their refresh have been designed and made available on the market: an example of such integrated circuits is the SN74ACT4503 device manufactured by Texas Instruments and illustrated in Texas Instruments' DATA-SHEET, September 1988, revised November 1988, pages 1 to 18; such control integrated circuits are capable of handling a predetermined maximum amount of memory.

When a system needs an amount of dynamic random access memory greater than such predetermined maximum amount, such memory is organized in two or more banks and two or more control integrated circuits are used one for each bank.

The presence or several control integrated circuits implies an increase in the costs of the system and in the room taken up on the card.

It is an object of the present invention to overcome the drawbacks of the known art.

This object is reached through the dynamic RAM controller, as set forth in claim 1, and through the circuit for driving a plurality or dynamic random access memory banks, as set forth in claim 7.

Further advantageous aspects of the present invention are set forth in the subclaims.

By making a dynamic RAM controller output its current operation mode (access/refresh), it is possible to extend at will the addressing capabilities of the controller itself; therefore a sole controller is capable of handling several memory banks by simply adding a decoding logic for selecting the bank during the access operation mode.

In this manner an advantage is further obtained in that the refresh time is bound to the structure and dimension of the memory bank and not to the number of memory banks since the refresh occurs in parallel on all the memory banks.

The present invention will become more apparent from the following description taken in conjunction with the attached drawings wherein:
- Fig. 1 is a block diagram of a first embodiment of the controller in accordance with the present invention,
- Fig. 2 is a block diagram of a second embodiment of the controller in accordance with the present invention, and
- Fig. 3 is a circuit diagram of a possible embodiment of the circuit according to the present invention connected to four dynamic random access memory banks, only one of which being represented.

The dynamic RAM controller, according to the present invention, is designed to be connected with a dynamic random access memory bank and operates in accordance with a current operation mode selected from the set comprising at least a first (access) operation mode to such bank and a second (refresh) operation mode of such bank.

It outputs at least one state signal ST corresponding to the current operation mode; this can be made either upon request or, more advantageously, in a continuous manner.

The access operation mode is subdivided at least into a write operation mode and into a read operation mode; moreover, there can be further operation modes, e.g., for the memory bank test and for testing the controller itself; moreover, the "non operation" mode can be considered also as a special operation mode in which no operation is carried out, neither on the bank nor on the controller.

The controller can comprise register means STR designed to store the current operation mode and output it, through the state signal ST, of course.

When the operation modes between which it is of interest to discriminate are only two, the register means can merely be constituted by a D-Flip-Flop whose state takes a binary value "1" when the current operation mode corresponds to refresh, and it takes the binary value "0" when the current operation mode corresponds to access. The information contained in such D-Flip-Flop is merely obtained by reading out the logical value present at its state output, generally denoted by "Q".

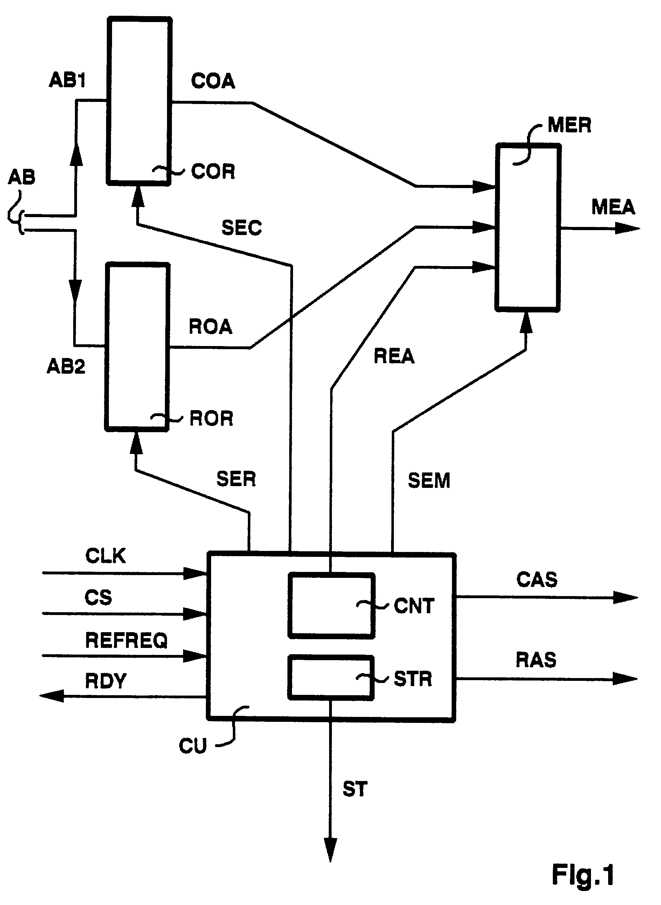

A first embodiment of the controller in accordance with the present invention is illustrated, through a block diagram, in Fig. 1.

It receives at its input an address bus AB composed by a plurality of address lines and comprises:
a) a column register COR, receiving at its input a first part AB1 of the plurality of address lines, and designed to store a column address COA and to output it,
b) a row register ROR, receiving at its input the remaining part AB2 of the plurality of address lines, and designed to store a row address ROA and to output it,
c) a memory register MER, receiving at its input the column address COA, the row address ROA and a refresh address REA, and designed to output, to the memory bank connected thereto, a memory address MEA selected from the addresses COA, ROA and REA, and
d) a control unit CU, receiving at its input, input control signals, and designed to output, output control signals and the refresh address REA.

The control unit CU comprises, in turn, register means STR and stores therein the current operation mode, determined by the received input control signals; the information contained in the register means STR is output by the control unit through the state signal ST.

Naturally the control unit CU serves to drive all the controller operation, that as to normal operations and relative structure does not differ from the operation of the control integrated circuits already present or the market, such as the above-mentioned SN74ACT4503 device.

The control unit will send the registers COR, ROR and MER respective selection signals SEC, SER and SEM moreover, it will have to generate at least a CAS signal and at least a RAS signal for the memory bank.

Yet, the control unit will receive at its input an enable signal CS and will output a ready signal RDY; the activation of signal CS indicates to the controller the request for accessing the memory bank, the control unit CU will answer this request through the RDY signal.

It is possible to provide that device eternal to the controller has a certain control over the refresh operation: the control unit CU can then receive a request signal REFREQ for the starting of the refresh operation.

If the controller carries out the refresh operation in an autonomous manner, the control unit can comprise a counter CNT for generating the refresh address REA.

Naturally such a controller in accordance with the present invention can be advantageously realized through an integrated circuit by providing that at least one terminal of the integrated circuit is corrected to the register means STR.

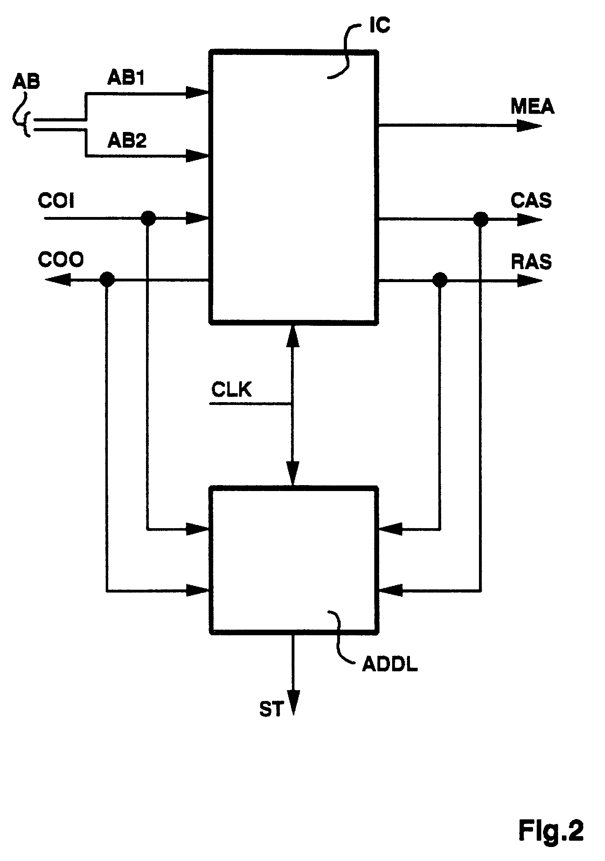

A second embodiment of the controller in accordance with the present invention is illustrated through a block diagram, in Fig. 2.

It comprises:
a) A control integrated circuit IC for dynamic RAMs not outputting information about its own current operation mode and provided with input (COI) and output (COO) control signals, and
b) an additional logic ADDL connected to the integrated circuit IC and capable of generating the state signal ST, computed at least on the basis of the control signals COI and COO, corresponding to said current operation mode.

The control integrated circuit IC can be selected from the many available on the market, for instance the above-mentioned SN74ACT4503; the input (COI) and output (COO) control signals depend on the selected integrated circuit and may comprise, e.g., a selection signal, a ready signal, a refresh operation start request signal, and so on; naturally the integrated circuit IC will receive the address bus AB and will output the memory address MEA and at least one RAS and one CAS signals.

The additional logic ADDL will differ remarkably depending on the selected type of integrated circuit IC and in particular on the number and type of control signals COI and COO available to it; in some instances it will be necessary to provide the logic ADDL also with CAS and RAS signals generated by the integrated circuit IC; in general it will be a sequential logic but it cannot be excluded that, in particularly advantageous cases, a people skilled in the art will be able to obtain a purely combinatory realization capable of determining the current operation mode on the basis of signals fed at its input.

Should the additional logic ADDL be sequential, it will then comprise at least the register means STR.

It is obvious that the integrated circuit IC and, if sequential, the additional logic ADDL receive at their input a clock signal CLK.

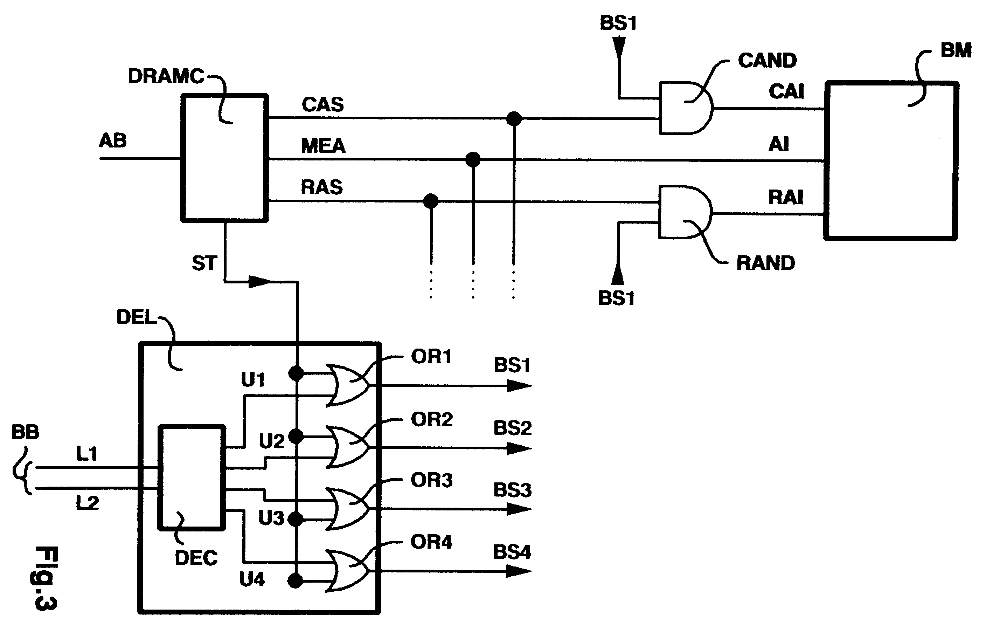

In fig. 3 there is represented a circuit diagram of a possible realization of the circuit, in accordance with the present invention, connected with four dynamic random access memory banks, only one of which being represented and denoted by BM.

Such circuit comprises:
a) a dynamic RAM controller DRAMC, operating in accordance with a current operation mode selected from the set comprising at least a first (access) operation mode and a second (refresh) operation mode, receiving at its input a first address bus AB comprised of a plurality of address lines and outputting a memory address MEA, and a state signal ST corresponding to said current operation mode, and
b) a decoding logic DEL receiving at its input a bank address through a second address bus BB (comprised of two lines L1 and L2 in this realization) and the state signal ST.

The decoding logic DEL selects all the four banks when the controller DRAMC operates in accordance with the second (refresh) operation mode, and selects one bank, individuated by the bank address when controller DRAMC operates in accordance with the first (access) operation mode.

Controller DRAMC can be selected, e.g., from one of the two realizations of the present invention described previously; it generates at least one RAS signal and at least one CAS signal; naturally it will receive at its input and will output several further signals not shown in Fig. 3 and necessary for its operation.

In the realization of Fig. 3 the decoding logic DEL receives at its input the two lines L1 and L2 and the state signal ST (having logical value "1" when a refresh operation is in progress) and outputs four bank selection signals BS1, BS2, BS3, BS4; the two lines of bus BB are entered a decoder DEC having four outputs U1, U2, U3, U4; the logical value of such outputs is provided by the following table

| L1/L2 | U1 | U2 | U3 | U4 |
|---|---|---|---|---|
| 0/0 | 1 | 0 | 0 | 0 |
| 0/1 | 0 | 1 | 0 | 0 |
| 1/0 | 0 | 0 | 1 | 0 |
| 1/1 | 0 | 0 | 0 | 1 |

Outputs U1, U2, U3, U4 are then fed to the first inputs of four two-input OR-gates designated by OR1, OR2, OR3, OR4 respectively; the second inputs of gates OR1, OR2, OR3, OR4 are connected in parallel with state signal ST; the outputs of the four gates constitute the four bank signals, respectively.

It is evident that when a refresh operation is in progress, the four signals BS1, BS2, BS3, BS4 all take the logical value "1", while when an access operation is in progress, only one of them will take the logical value "1", i.e. the one from the sole OR-Gate receiving at its first input a signal having logical value "1".

Bank selection signals BS1, BS2, BS3, BS4 could be used for directly selecting four dynamic RAM banks; dynamic RAMs are not often provided With a selection input as in the realization of Fig. 3.

In the following reference will be made to a sole memory bank BM (the sole represented in Fig. 3), the same consideration applying to the other three barks as well.

Dynamic random access memory bank BM is provided with an address input AI, a CAS-input CAI and a RAS-input RAI (active high in the realization); moreover, there is at least a data input/output not shown. The selection of the bank occurs automatically when inputs CAI and/or RAI are activated.

In order to drive the selection of the bank BM two 2-input AND-gates have been then prearranged, respectively one gate RAND for the RAS signal and one gate CAND for the CAS signal.

The first input of gate CAND receives the CAS signal from The first input of gate CAND receives the CAS signal from controller DRAMC and the second input receives the corresponding bank select signal (signal BS1 in Fig. 3) and the output of gate CAND is connected with input CAI of bank BM.

The first input of gate RAND receives the RAS signal from controller DRAMC and the second input receives the corresponding bank select signal (signal BS1 in Fig. 3) and the output of gate RAND is connected with input RAI of bank BM.

It is evident that, in order to be able to use the bank BM, the respective bank select signal (signal BS1 in Fig. 3) must have logical value "1".

Naturally, should a greater number of memory banks be necessary, it is very easy to those skilled in the art to extend thereto the proposed circuital solution.

## Claims

1. Dynamic RAM controller, designed to be connected to a bank of dynamic RAMs operating in accord to a current operation mode selected from the set comprising at least a first operation mode of access to said bank and a second operation mode of refresh of said bank, characterized in that it outputs at least one state signal corresponding to said current operation mode.

2. Controller according to claim 1, characterized in that it comprises register means for storing said current operation mode and output it.

3. Controller according to claim 2, receiving at its input an address bus composed of a plurality of address lines, comprising:
a) a column register, receiving at its input a first part of said plurality of address lines and designed to store a column address and output it,
b) a row register receiving at its input the remaining part of said plurality of address lines, and designed to store a row address and to output it,
c) a memory register, receiving at its input said column address, said row address and a refresh address, and capable of outputting to said bank a memory address selected from said addresses, and
d) a control unit receiving at its input, input control signals, and capable of outputting output control signals and said refresh address;
wherein said control unit comprises said register means and wherein said current operation mode depends on said received input control signals.

4. Controller according to claim 1, comprising:
a) a dynamic RAM control integrated circuit not outputting information about its current operation mode and provided with input and output control signals, and
b) an additional logic connected with said integrated circuit and capable of generating said state signal, calculated at least on the basis of said control signals, corresponding to said current operation mode.

5. Controller according to claims 2 and 4, characterized in that said additional logic is a sequential logic and comprises said register means.

6. Controller according to claim 1, characterized by being realized through an integrated circuit having at least one terminal for said state signal.

7. Circuit for driving a plurality of banks of dynamic RAMs, comprising:
a) a dynamic RAM controller operating in accordance with a current operation mode selected from the set comprising at least a first (access) operation mode and a second (refresh) operation mode, receiving at its input a first address bus composed by a plurality of address lines and outputting a memory address, and a state signal corresponding to said current operation mode, and:
b) a decoding logic, receiving at its input a bank address through a second address bus and said state signal,
wherein said decoding logic selects all the banks of said plurality of banks when said controller operates in accordance with said second (refresh) operation mode, and selects one bank, individuated by said bank address, when said controller operates in accordance with said first (access) operation mode.

8. Circuit according to claim 7, wherein said decoding logic selects said plurality of banks by acting on their CAS and RAS input signals.

9. Dynamic RAM controller and circuit for driving a plurality of banks of dynamic RAMs as hereinbefore described, illustrated and claimed.
